# EUROPÄISCHE PATENTSCHRIFT

(11) **EP 1 891 453 B1**
(45) Veröffentlichungstag und Bekanntmachung des Hinweises auf die Patenterteilung: **05.11.2008**
(21) Anmeldenummer: 07725540.4
(22) Anmeldetag: 24.05.2007
(51) Int. Cl.: G01R 31/28, G01M 7/04

(54) **BESCHLEUNIGUNGSVORRICHTUNG ZUM TESTEN VON ELEKTRONISCHEN BAUELEMENTEN**
ACCELERATION DEVICE FOR TESTING ELECTRONIC COMPONENTS
DISPOSITIF D'ACCÉLÉRATION DESTINÉ À TESTER DES COMPOSANTS ÉLECTRONIQUES

(30) Priorität: 31.05.2006 DE 102006025341
(43) Veröffentlichungstag der Anmeldung: 27.02.2008
(73) Patentinhaber: Multitest elektronische Systeme GmbH, 83026 Rosenheim (DE)
(72) Erfinder: KIERMEIER, Arnfried, 83080 Oberaudorf (DE); KLIER, Michael, 83620 Feldkirchen-Westerham (DE); Mühlbauer, Josef, 83083 Riedering (DE)
(74) Vertreter: Bauer, Friedrich
(86) Internationale Anmeldenummer: PCT/EP2007/004644
(87) Internationale Veröffentlichungsnummer: WO 2007/137768

(56) Entgegenhaltungen:
- EP-A2- 0 909 895
- DE-U- 7 015 469
- US-A- 4 499 772
- US-A- 5 492 313
- US-A- 6 050 556

## Beschreibung

Die Erfindung betrifft einen Handler zum Testen von elektronischen Bauelementen, mit einem Nest zur Aufnahme der Bauelemente und einer Beschleunigungsvorrichtung, mit der die im Nest gehalterten Bauelemente Beschleunigungstests unterzogen werden, wobei die Beschleunigungsvorrichtung einen Stößel, an dem das Nest befestigbar ist, sowie eine Bewegungserzeugungseinrichtung zur Beschleunigung des Stößels in axialer Richtung aufweist.

Handler (Handhabungsvorrichtungen) dienen bekanntermaßen dazu, elektronische Bauelemente wie beispielsweise IC's einem Testkopf einer Testvorrichtung zuzuführen, um die Bauelemente mit dem Testkopf zu kontaktieren und elektrischen Tests zu unterziehen. Sollen die Bauelemente Beschleunigungstests unterzogen werden, wird das nach Bedarf temperierte Bauteil einem Nest zugeführt, mit der Testvorrichtung kontaktiert und z.B. in Richtung senkrecht zur Kontaktierebene des Bauteils beschleunigt.

Als Handler wird in diesem Zusammenhang ausdrücklich auch eine Vorrichtung bezeichnet, bei der die Bauteile nicht automatisch dem Nest zugeführt werden, sondern das Nest von Hand bestückt wird.

Die Beschleunigungsvorrichtung weist hierzu bekanntermaßen einen Stößel mit einem freien Ende auf, an dem das Nest befestigbar ist. Der Stößel wird von einer Bewegungserzeugungseinrichtung in axialer Richtung hin- und her bewegt. Die Bewegungserzeugungseinrichtung kann beispielsweise aus einer Spule bestehen und nach dem Lautsprecherprinzip arbeiten.

Bei derartigen Beschleunigungstests können sich die Frequenzen vom niedrigen Herzbereich bis in den Kiloherzbereich bewegen. Der Beschleunigungsweg kann von wenigen Mikrometern bis zu mehreren Zentimetern betragen.

Hierbei besteht das Problem, dass durch die Bewegungserzeugungseinrichtung, beispielsweise Spule, Nebenbeschleunigungen in nicht beabsichtigten Raumrichtungen und auch Drehbewegungen auf den Stößel und damit das zu testende Bauelement übertragen werden können, wodurch die Messergebnisse verfälscht werden können. Ein weiteres Problem besteht darin, dass die Lager zur linearen Führung des Stößels durch die teilweise sehr hohen Bewegungsfrequenzen und durch Temperaturbereiche von -55°C bis +155°C, in denen diese Tests durchgeführt werden, extremen Belastungen ausgesetzt sind. Übliche Lager halten derartigen Belastungen in der Regel nicht stand und haben nicht die gewünschte Haltbarkeit.

Aus der US 4,499,772 ist eine flexible Haltescheibe zur axial beweglichen Lagerung eines Stößels bekannt, an dem ein Testgerät befestigt werden kann. Diese Haltescheibe weist einen kreisringförmigen Umfangsbereich auf, mit dem die Haltescheibe an einem Gehäuse befestigt werden kann. Der Umfangsbereich begrenzt eine vollflächige, gewellte Scheibe, die in ihrem Mittelpunkt vom Stößel durchdrungen ist und damit den Stößel radial abstützt.

Aus der US 5,492,313 ist eine Federscheibe mit einem ringförmigen Umfangsbereich bekannt, über den die Federscheibe an einem Gehäuse befestigbar ist. Innerhalb des Umfangsbereichs sind Federarme angeordnet, die zur axial federnden Abstützung eines innenliegenden, dreieckigen Halteelements dient. An diesem dreieckigen Halteelement kann ein durch das Halteelement hindurchgeführter Stößel befestigt werden, um den Stößel radial abzustützen.

Der Erfindung liegt die Aufgabe zugrunde, einen Handler der eingangs genannten Art mit einer Beschleunigungsvorrichtung zu schaffen, die bei einfachem Aufbau unerwünschte Nebenbeschleunigungen und/oder Drehungen des Stößels vermeidet und eine hohe Haltbarkeit aufweist und bei kleiner Baugröße eine große Auslenkung des Stößels ermöglicht.

Diese Aufgabe wird erfindungsgemäß durch einen Handler mit den Merkmalen des Anspruchs 1 gelöst. Vorteilhafte Ausführungsformen der Erfindung sind in den weiteren Ansprüchen beschrieben.

Erfindungsgemäß weist die Federscheibe einen ringförmigen Umfangsbereich und zwei Gruppen von durch den Umfangsbereich miteinander verbundenen Federarmen auf, wobei eine Gruppe am Stößel und die andere Gruppe am Rahmen befestigt ist und wobei sich die Federarme, an denen der Stößel befestigt ist, und die Federarme, mit denen die Federscheibe am Rahmen befestigt ist, vom ringförmigen Umfangsbereich nach innen oder außen erstrecken.

Mit Hilfe einer derartigen Federscheibe kann vermieden werden, dass der Stößel in unerwünschten Richtungen bewegt bzw. beschleunigt wird. Soll beispielsweise der Stößel in z-Richtung hin- und herbewegt werden, so vermeidet die Federscheibe, dass sich der Stößel in x- und y-Richtung bewegt oder sich um seine Längsachse dreht. Dadurch, dass die eine Gruppe von Federarmen fest am Stößel und die andere Gruppe fest am Rahmen befestigt ist, sind keine Wälz- oder Gleitbewegungen zwischen dem Stößel und der Federscheibe einerseits und der Federscheibe und dem Rahmen andererseits vorhanden, so dass unerwünschte Erwärmungen und Verschleißerscheinungen in diesen Bereichen vermieden werden können. Die Federscheibe gewährleistet damit eine sehr präzise, lineare Führung des Stößels in der gewünschten Richtung mit geringem Verschleiß und hoher Haltbarkeit bei kleiner Baugröße.

Gemäß einer vorteilhaften Ausführungsform weist jede Gruppe zwei bis sechs, insbesondere drei bis fünf, Federarme auf. Besonders bevorzugt sind hierbei drei bis vier Federarme pro Gruppe, da bei einer derartigen Anzahl einerseits der Stößel nach allen Richtungen quer zu seiner Längsachse definiert abgestützt und andererseits ein sehr einfacher Aufbau der Federscheibe möglich ist.

Gemäß einer vorteilhaften Ausführungsform erstrecken sich die Federarme von dem ringförmig geschlossenen Umfangsbereich zumindest im Wesentlichen radial nach innen. Dies ermöglicht eine sehr kompakte Bauform der Federscheibe. Alternativ hierzu ist es jedoch auch grundsätzlich möglich, dass sich die eine Gruppe von Federarmen, die mit dem Stößel verbunden ist, vom ringförmig geschlossenen Umfangsbereich nach innen und die andere Gruppe von Federarmen, die mit dem Rahmen verbunden ist, vom ringförmig geschlossenen Umfangsbereich nach außen erstreckt. Weiterhin können sich auch alle Federarme nach außen erstrecken, beispielsweise wenn der Stößel rohrförmig ausgebildet und die Federscheibe im Inneren des Stößels angeordnet ist.

Bevorzugt ist der Umfangsbereich kreisringförmig ausgebildet. Alternativ hierzu ist es jedoch auch möglich, dass der Umfangsbereich eine andere Form, beispielsweise eine mehreckige Form, hat.

Bevorzugt sind die Federarme in Umfangsrichtung der Federscheibe gleichmäßig verteilt angeordnet. Hierdurch wird eine gleichmäßige Krafteinleitung auf die Federscheibe und eine gleichmäßige Kraftübertragung von dem Stößel auf den Rahmen gewährleistet.

Die Federarme können geradlinig oder gekrümmt ausgebildet sein, wobei sie im letzteren Fall vorzugsweise einen S-förmig gebogenen Abschnitt aufweisen. Während die geradlinige Ausführung der Federarme eine sehr einfache und kostengünstige Herstellung der Federscheibe ermöglicht, haben gekrümmte Federarme den Vorteil, dass damit besonders große Auslenkungen bei einer kleinen Baugröße ermöglicht werden, da durch die Krümmung die Länge der Federarme vergrößert wird.

Die S-förmig gebogenen Abschnitte aller Federarme können gleichgerichtet angeordnet sein. Alternativ hierzu ist es jedoch auch möglich, dass die S-förmig gebogenen Abschnitte eines Teils der Federarme, vorzugsweise der Hälfte aller Federarme, gegenläufig zu den S-förmig gebogenen Abschnitten des anderen Teils der Federarme ausgerichtet sind. Hierdurch können sich mögliche Drehkräfte um die Längsachse des Stößels, welche beim Hin- und Herbewegen des Stößels von den einzelnen Federarmen erzeugt werden, gegenseitig aufheben.

Bevorzugt sind die Federarme an Befestigungsstellen mit dem Stößel und dem Rahmen verbunden, die auf einem gemeinsamen Kreis liegen. Hierüber wird der Stößel auf besonders gleichmäßige Weise nach allen Seiten hin abgestützt.

Gemäß einer weiteren Ausführungsform ist der Stößel durch mindestens zwei axial beabstandete Federscheiben linear geführt. Hierbei kann eine erste Federscheibe in Nachbarschaft des Nest und mindestens eine weitere Federscheibe in Nachbarschaft der Bewegungserzeugungseinrichtung, entweder auf derselben Seite wie die erste Federscheibe oder jenseits der Bewegungserzeugungseinrichtung, angeordnet sein. Die radiale Abstützung des Stößels durch mehrere Federscheiben ermöglicht eine besonders gute Linearführung des Stößels in der gewünschten Richtung. Die Anordnung mindestens einer weiteren Federscheibe jenseits der Bewegungserzeugungseinrichtung ist dabei selbstverständlich nur bei Beschleunigungsvorrichtungen möglich, bei denen der Stößel durch die Bewegungserzeugungseinrichtung hindurchtritt und über deren Rückseite vorsteht.

Die Erfindung wird nachfolgend anhand der Zeichnungen beispielhaft näher erläutert. Es zeigen:
- Figur 1 :: eine schematische Darstellung einer Beschleunigungsvorrichtung für einen Handler, um elektronische Bauelemente Beschleunigungstests zu unterziehen,
- Figur 2 :: eine vergrößerte Darstellung der am Stößel und an einem Abschnitt des Rahmens befestigten Federscheibe,
- Figur 3 :: eine Vorderansicht der Federscheibe von Figur 2 in Alleinstellung,
- Figur 4 :: eine Seitenansicht der Federscheibe von Figur 3,
- Figur 5 :: eine zweite Ausführungsform einer Federscheibe, und
- Figur 6 :: eine dritte Ausführungsform einer Federscheibe.

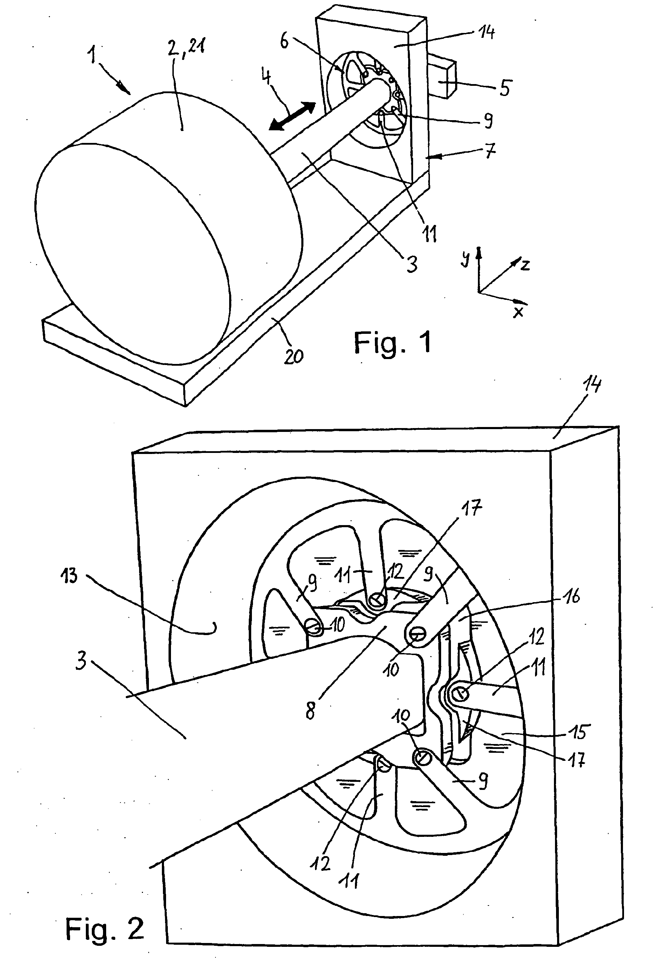

In Figur 1 ist eine Beschleunigungsvorrichtung 1 dargestellt, die zum Einbau in einem Handler für elektronische Bauelemente bestimmt ist, um nicht näher dargestellte elektronische Bauelemente wie IC's einem Beschleunigungstest zu unterziehen.

Hierzu weist die Beschleunigungsvorrichtung 1 eine Bewegungserzeugungseinrichtung 2, beispielsweise eine Spule, auf, mit deren Hilfe ein Stößel 3 in Axialrichtung, d.h. in Richtung des Pfeils 4, mit einer bestimmten Frequenz hin- und herbewegt werden kann. Die Testfrequenz ist hierbei von der Art des Bauelements und vom gewünschten Einsatzzweck abhängig und kann von wenigen Herz bis mehrere Kiloherz betragen. Beim Stößel 3 handelt es sich im dargestellten Ausführungsbeispiel um einen geradlinigen Stab, der beispielsweise einen runden Querschnitt aufweist, jedoch auch andere Querschnittsformen haben kann.

Am freien Ende des Stößels 3 ist ein Nest 5 befestigbar, d.h. eine Aufnahmevorrichtung, in der das zu testende Bauelement gehaltert ist. Wird der Stößel 3 in Richtung des Pfeils hin- und herbewegt, so wird entsprechend das Nest 5 und damit das Bauelemente ebenfalls in dieser Richtung bewegt.

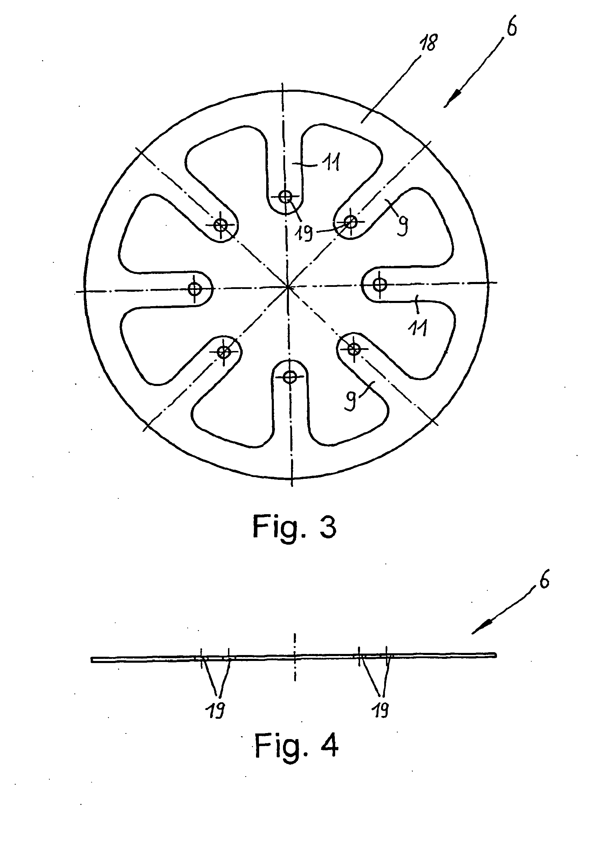

Der Stößel 3 ist mittels einer in den Figuren 3 und 4 näher dargestellten Federscheibe 6 derart an einem Rahmen 7 linear geführt, dass sich der Stößel 3 nur in Richtung des Pfeils 4, d.h. in z-Richtung, hin- und herbewegen kann, während Nebenbewegungen und damit auch Nebenbeschleunigungen quer zur z-Richtung, d.h. in x- oder y-Richtung, sowie Drehbewegungen um die Längsachse des Stößels 3 vermieden werden. Hierzu weist der Stößel 3 einen in Figur 2 näher dargestellten Befestigungsflansch 8 auf, der fest mit dem Stößel 3 verbunden, beispielsweise angeformt, aufgeschweißt oder aufgeschrumpft ist.

Mit dem Befestigungsflansch 8 sind eine Gruppe von Federarmen 9 der Federscheibe 6 fest verbunden, insbesondere mittels Schrauben 10 festgeschraubt, während eine andere Gruppe von Federarmen 11 mit dem Rahmen 7 verbunden, insbesondere mittels Schrauben 12 festgeschraubt ist. Hierbei ist die Federscheibe 6 ausschließlich über die Federarme 11 mit dem Rahmen 7 in Kontakt. Die Federscheibe 6 ist somit, wie aus den Figuren 1 und 2 ersichtlich, derart in eine Öffnung 13 des Rahmens 7 eingesetzt, dass die Federscheibe 6 mit ihrem Außenumfang die Innenumfangswand der Öffnung 13 nicht berührt.

Im dargestellten Ausführungsbeispiel hat die Öffnung 13 die Form einer kreisförmigen Bohrung, die ein Vertikalelement 14 des Rahmens 7 in z-Richtung nicht vollständig durchdringt, so dass eine Wand 15 gebildet wird, die sich von der Umfangswand der Öffnung 13 radial nach innen erstreckt und dadurch eine Schulter bildet. In der Wand 15 ist eine mittige, axiale Durchgangsöffnung 16 vorgesehen, die derart ausgebildet ist, dass der Stößel 3 zusammen mit dem Befestigungsflansch 8 hindurchtreten kann.

Wie aus Figur 2 ersichtlich, sind an der Wand 15 vier sockelartige Vorsprünge 17 vorgesehen, die in der Nähe der Durchgangsöffnung 16 angeordnet sind und in axialer Richtung über die Wand 15 vorstehen. Die Vorsprünge 17 sind regelmäßig verteilt und um die Durchgangsöffnung 16 an denjenigen Stellen angeordnet, an denen sich die inneren Enden der Federarme 11 befinden. Wie ersichtlich, sind die Federarme 11 mittels der Schrauben 12 auf den Vorsprüngen 17 befestigt, so dass sich der übrige Teil der Federarme 11 mit Abstand zur Wand 15 nach außen erstreckt. Auf diese Weise können sich die Federarme 11 außerhalb der Vorsprünge 17 in axialer Richtung bewegen, ohne an der Wand 15 anzustoßen.

Die Federarme 9 sind mit ihren inneren Enden in den vier Eckenbereichen des Befestigungsflansches 8 befestigt.

Im folgenden wird die in den Figuren 1 und 2 gezeigte Federscheibe 6 anhand der Figuren 3 und 4 näher erläutert. Die Federscheibe 6 ist nach Art einer ebenen Tellerfeder ausgebildet und weist einen ringförmigen Umfangsbereich 18 mit kreisförmiger Außenkontur auf. Von diesem Umfangsbereich 18 erstrecken sich vier Federarme 9 und vier Federarme 11 geradlinig radial nach innen. Die Federarme 9 und die Federarme 11 wechseln sich, in Umfangsrichtung gesehen ab, d.h., nach einem Federarm 9 folgt in Umfangsrichtung ein Federarm 11, anschließend wieder ein Federarm 9 usw.. Die Federarme 9, 11 sind in Umfangsrichtung regelmäßig verteilt angeordnet, d.h., die Längsachsen benachbarter Federarme 9, 11 schließen zueinander einen Winkel von 45° ein und treffen sich im Mittelpunkt der Federscheibe 6 (Figur 3). Die Federarme 9, 11 haben weiterhin dieselbe Länge, die so bemessen ist, dass die inneren Enden der Federarme 9, 11 auf einem Kreis mit einem Durchmesser liegen, der größer ist als der Außendurchmesser des Stößels 3. In den inneren Endbereichen der Federarme 9, 11 sind Bohrungen 19 vorgesehen, durch die die Schrauben 10, 12 (Figur 2) hindurch geführt werden können. Die Bohrungen 19 aller Federarme 9, 11 liegen auf einem konzentrischen Kreis um den Mittelpunkt der Federscheibe 6.

Die Breite der Federarme 9, 11 entspricht im vorliegenden Ausführungsbeispiel in etwa der Breite des Umfangsbereichs 18, kann jedoch in Abhängigkeit der jeweiligen Anforderungen variieren. Der Durchmesser desjenigen Kreises, auf dem die Mittelpunkte der Bohrungen 19 liegen, beträgt im Ausführungsbeispiel von Figur 3 etwa 46% des Außendurchmessers der Federscheibe 6, kann jedoch in Abhängigkeit der Anforderungen in weitem Umfang variieren. Weiterhin ist es nicht unbedingt erforderlich, dass die Federarme 9, 11 alle dieselbe Länge haben. Es ist auch vorstellbar, dass die Federarme 9 eine andere Länge als die Federarme 11 haben, oder dass die Federarme einer Gruppe auch untereinander unterschiedliche Längen haben.

Die Funktion der Federscheibe 6 ist derart, dass die vom Stößel 3 über den Befestigungsflansch 8 auf die Federarme 9 aufgebrachten Kräfte über den Umfangsbereich 18 auf die Federarme 11 übertragen und von diesen auf das Vertikalelement 14 des Rahmens 7 weitergeleitet werden. Über die Federarme 9, 11 ist der Stößel 3 somit in radialer Richtung gegenüber dem Rahmen 7 abgestützt, kann sich jedoch gleichzeitig in axialer Richtung hin- und herbewegen.

Das Vertikalelement 14 des Rahmens 7 ist wiederum, wie aus Figur 1 ersichtlich, mit einem Horizontalelement 20 fest verbunden, an dem ein Gehäuse 21 der Bewegungserzeugungseinrichtung 2 befestigt ist.

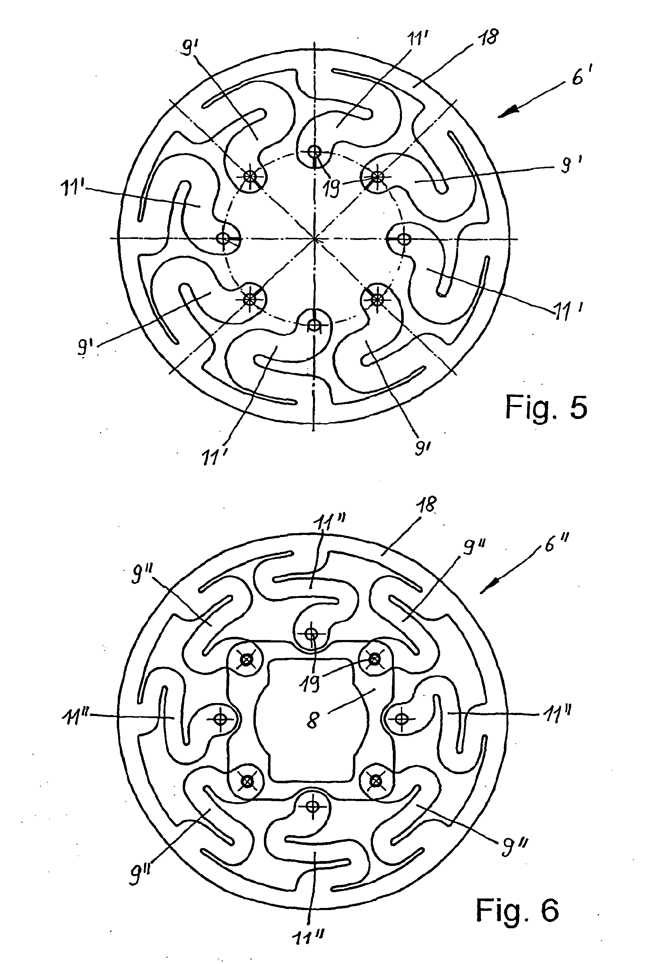

Aus Figur 5 ist eine zweite Ausführungsform einer Federscheibe 6' ersichtlich, die vom Prinzip her ähnlich wie die Federscheibe 6 ausgebildet ist, jedoch anstelle von geraden Federarmen 9, 11 gekrümmte Federarme 9', 11' aufweist. Die Federarme 9', 11' haben einen S-förmig gebogenen Abschnitt bzw., je nach dem, von welcher Seite auf die Federscheibe 6' geblickt wird, einen gebogenen Abschnitt in der Form eines spiegelverkehrten "S". Aufgrund der gebogenen Abschnitte weisen die Federarme 9', 11' somit Abschnitte auf, die sich zumindest im Wesentlichen in Umfangsrichtung der Federscheibe 6' erstrecken, wodurch die Länge der Federarme 9', 11' verlängert werden kann, obwohl ihre inneren Enden auf einem Kreis mit dem gleichen Durchmesser wie bei der Federscheibe 6 liegen. Dies kann größere Auslenkungen in axialer Richtung des Stößels 3 ermöglichen.

Weiterhin ist aus Figur 5 ersichtlich, dass die gebogenen Abschnitte aller Federarme 9', 11' gleich gerichtet angeordnet sind, d.h., die gebogenen Abschnitte erstrecken sich alle in die selbe Umfangsrichtung.

Aus Figur 6 ist eine weitere Ausführungsvariante einer Federscheibe 6" ersichtlich, die ganz ähnlich wie die Federscheibe 6' von Figur 5 ausgebildet ist und daher auch sich vom Umfangsbereich 18 radial nach innen schlängelnde Federarme 9", 11" aufweist. Hier ist jedoch die Hälfte der gebogenen Abschnitte der Federarme 9" gegenläufig zu den gebogenen Abschnitten des anderen Teils der Federarme 9" ausgerichtet. In gleicher Weise sind die gebogenen Abschnitte der Hälfte der Federarme 11" gegenläufig zu den gebogenen Abschnitten des anderen Teils der Federarme 11" ausgerichtet. Durch die gegenläufige Orientierung der gebogenen Abschnitte wird hier erreicht, dass Drehkräfte, die bei einer Axialbewegung der Federarme 9", 11" von diesen selbst erzeugt werden, sich gegenseitig aufheben.

Als Materialien für die Federscheiben 6, 6', 6" können verschiedenste Materialien gewählt werden, welche den auftretenden Belastungen standhalten, beispielsweise Federstähle oder Glasfaserverbundwerkstoffe. Endanschläge können eine Überstrapazierung der Vorrichtung in der gewünschten Auslenkungsvorrichtung verhindern.

## Patentansprüche

1. Handler zum Testen von elektronischen Bauelementen, mit einem Nest (5) zur Aufnahme der Bauelemente und einer Beschleunigungsvorrichtung (1), mit der die im Nest gehalterten Bauelemente Beschleunigungstests unterzogen werden,
wobei die Beschleunigungsvorrichtung (1) aufweist:
- einen Stößel (3), an dem das Nest (5) befestigt ist,
- eine Bewegungserzeugungseinrichtung (2) zur Beschleunigung des Stößels (3) in axialer Richtung, wobei die Bewegungserzeugungseinrichtung (2) ein Gehäuse (21) aufweist,
- einen relativ zum Gehäuse (21) feststehenden Rahmen (7),
- mindestens eine Federscheibe (6, 6', 6"), durch die der Stößel (3) am Rahmen (7) linear geführt ist, wobei die Federscheibe (6, 6', 6") einen ringförmigen Umfangsbereich (18) und zwei Gruppen von durch den Umfangsbereich (18) miteinander verbundenen Federarmen (9, 9', 9"; 11, 11', 11") aufweist, wobei eine Gruppe am Stößel (3) und die andere Gruppe am Rahmen (7) befestigt ist und wobei sich die Federarme (9, 9', 9"), an denen der Stößel (3) befestigt ist, und die Federarme (11, 11', 11"), mit denen die Federscheibe (6, 6', 6") am Rahmen (7) befestigt ist, vom ringförmigen Umfangsbereich (18) nach innen oder außen erstrecken.

2. Handler nach Anspruch 1, **dadurch gekennzeichnet, dass** jede Gruppe zwei bis sechs, insbesondere drei bis fünf, Federarme (9, 9', 9"; 11, 11', 11") aufweist.

3. Handler nach Anspruch 1 oder 2, **dadurch gekennzeichnet, dass** sich die Federarme (9, 9', 9"; 11, 11', 11") von dem ringförmig geschlossenen Umfangsbereich (18) zumindest im Wesentlichen radial nach innen erstrecken.

4. Handler nach Anspruch 3, **dadurch gekennzeichnet, dass** der Umfangsbereich (18) kreisringförmig ausgebildet ist.

5. Handler nach einem der vorhergehenden Ansprüche, **dadurch gekennzeichnet, dass** die Federarme (9, 9', 9"; 11, 11', 11") in Umfangsrichtung der Federscheibe (6, 6', 6") gleichmäßig verteilt angeordnet sind.

6. Handler nach einem der vorhergehenden Ansprüche, **dadurch gekennzeichnet, dass** die Federarme (9, 11) geradlinig ausgebildet sind.

7. Handler nach einem der Ansprüche 1 bis 5, **dadurch gekennzeichnet, dass** die Federarme (9', 9"; 11', 11") gekrümmt ausgebildet sind.

8. Handler nach Anspruch 7, **dadurch gekennzeichnet, dass** die Federarme (9', 9"; 11', 11") einen S-förmig gebogenen Abschnitt aufweisen.

9. Handler nach Anspruch 8, **dadurch gekennzeichnet, dass** die S-förmig gebogenen Abschnitte aller Federarme (9', 11') gleich gerichtet angeordnet sind.

10. Handler nach Anspruch 8, **dadurch gekennzeichnet, dass** die S-förmig gebogenen Abschnitte eines Teils der Federarme (9", 11"), vorzugsweise die Hälfte aller Federarme (9", 11"), gegenläufig zu den S-förmig gebogenen Abschnitten des anderen Teils der Federarme (9", 11") ausgerichtet sind.

11. Handler nach einem der vorhergehenden Ansprüche, **dadurch gekennzeichnet, dass** die Federarme (9, 9', 9"; 11, 11', 11") an Befestigungsstellen mit dem Stößel (3) und dem Rahmen (7) verbunden sind, die auf einem gemeinsamen Kreis liegen.

12. Handler nach einem der vorhergehenden Ansprüche, **dadurch gekennzeichnet, dass** der Stößel (3) durch mindestens zwei axial beabstandete Federscheiben (6, 6', 6") linear geführt ist.

13. Handler nach Anspruch 12, **dadurch gekennzeichnet, dass** mindestens eine erste Federscheibe (6, 6', 6") in Nachbarschaft des Nests (5) und mindestens eine weitere Federscheibe (6, 6', 6") in Nachbarschaft der Bewegungserzeugungseinrichtung (2), entweder auf derselben Seite wie die erste Federscheibe (6, 6', 6") oder jenseits der Bewegungserzeugungseinrichtung (2), angeordnet ist.

## Claims

1. A handler for testing electronic components comprising a nest (5) to receive the components, and an acceleration device (1) by which components held in the nest are subjected to acceleration tests, wherein the acceleration device (1) comprises:
- a plunger (3) to which the nest (5) is fixed,
- a movement generation device (2) for accelerating the plunger (3) in the axial direction, wherein the movement generation device (2) comprises a housing (21),
- a frame (7) which is stationary in relation to the housing (21),
- at least one spring washer (6, 6', 6") linearly guiding the plunger (3) on the frame (7), wherein the spring washer (6, 6', 6") comprises an annular peripheral area (18) and two groups of spring arms (9, 9', 9"; 11, 11', 11") which are connected with each other by means of the peripheral area (18), wherein one group is connected to the plunger (3) and the other group is connected to the frame (7) and wherein the spring arms (9, 9', 9") to which the plunger is connected, and the spring arms (11, 11', 11") by means of which the spring washer (6, 6', 6") is connected to the frame (7), extend inwards or outwards from the annular peripheral area (18).

2. The handler as claimed in Claim 1, wherein each group comprises two to six, in particular three to five, spring arms (9, 9', 9"; 11, 11', 11").

3. The handler as claimed in Claim 1 or 2, wherein the spring arms (9, 9', 9"; 11, 11', 11") extend at least substantially radially inwards from the circular closed peripheral area (18).

4. The handler as claimed in Claim 3, wherein the peripheral area (18) is of circular form.

5. The handler as claimed in any one of the preceding claims, wherein the spring arms (9, 9', 9"; 11, 11', 11") are arranged evenly distributed in the circumferential direction of the spring washer (6, 6', 6").

6. The handler as claimed in any one of the preceding claims, wherein the spring arms (9, 11) are formed in a straight-line.

7. The handler as claimed in any one of Claims 1 to 5, wherein the spring arms (9', 9"; 11', 11") are formed in a curve.

8. The handler as claimed in Claim 7, wherein the spring arms (9', 9"; 11', 11") have an S-shaped curved section.

9. The handler as claimed in Claim 8, wherein the S-shaped curved sections of all spring arms (9', 11') are arranged in parallel.

10. The handler as claimed in Claim 8, wherein the S-shaped curved sections of one part of the spring arms (9", 11"), preferably half of all spring arms (9", 11"), are aligned running counter to the S-shaped curved sections of the other part of the spring arms (9", 11").

11. The handler as claimed in any one of the preceding claims, wherein the spring arms (9, 9', 9"; 11, 11', 11") are connected to the plunger (3) and the frame (7) at fixing places, which lie on a common circle.

12. The handler as claimed in any one of the preceding claims, wherein the plunger (3) is linearly guided by means of at least two axially spaced spring washers (6, 6' 6").

13. The handler as claimed in Claim 12, wherein at least one first spring washer (6, 6', 6") is arranged adjacent to the nest (5) and at least one further spring washer (6, 6', 6") adjacent to the movement generation device (2) either on the same side as the first spring washer (6, 6', 6") or beyond the movement generation device (2).

## Revendications

1. Manipulateur pour tester des composants électroniques, comprenant un berceau (5) pour recevoir les composants et un dispositif d'accélération (1) avec lequel les composants tenus dans le berceau sont soumis à des tests d'accélération, ledit dispositif d'accélération (1) comprenant :
- un poussoir (3) sur lequel est fixé le berceau (5),
- un dispositif de génération de déplacement (2) pour accélérer le poussoir (3) en direction axiale, le dispositif de génération de déplacement (2) comportant un boîtier (21),
- un cadre (7) stationnaire par rapport au boîtier (21),
- au moins une plaque-ressort (6, 6', 6"), au moyen de laquelle le poussoir (3) est guidé linéairement sur le cadre (7), ladite plaque-ressort (6, 6', 6") comprenant une zone périphérique (18) de forme annulaire et deux groupes de bras à ressort (9, 9', 9" ; 11, 11', 11 ") reliés les uns aux autres par la zone périphérique (18), l'un des groupes étant fixé sur le poussoir (3) et l'autre groupe étant fixé sur le cadre (7), et les bras à ressort (9, 9', 9"), sur lesquels est fixé le poussoir (3), et les bras à ressort (11, 11', 11"), avec lesquels la plaque-ressort (6, 6', 6") est fixée sur le cadre (7), s'étendent vers l'intérieur ou vers l'extérieur depuis la zone périphérique (18) de forme annulaire.

2. Manipulateur selon la revendication 1, **caractérisé en ce que** chaque groupe comprend deux à six bras à ressort (9, 9', 9" ; 11, 11', 11"), en particulier de trois à cinq.

3. Manipulateur selon la revendication 1 ou 2, **caractérisé en ce que** les bras à ressort (9, 9', 9" ; 11, 11', 11") s'étendent au moins sensiblement radialement vers l'intérieur depuis la zone périphérique (18) fermée sous forme annulaire.

4. Manipulateur selon la revendication 3, **caractérisé en ce que** la zone périphérique (18) est réalisée sous forme de bague circulaire.

5. Manipulateur selon l'une des revendications précédentes, **caractérisé en ce que** les bras à ressort (9, 9', 9" ; 11, 11', 11 ") sont agencés de façon régulièrement répartie dans la direction périphérique de la plaque-ressort (6, 6', 6").

6. Manipulateur selon l'une des revendications précédentes, **caractérisé en ce que** les bras à ressort (9, 11) sont réalisés de manière rectiligne.

7. Manipulateur selon l'une des revendications 11 5, **caractérisé en ce que** les bras à ressort (9, 9', 9" ; 11, 11' 11 ") sont réalisés de manière cintrée.

8. Manipulateur selon la revendication 7, **caractérisé en ce que** les bras à ressort (9', 9" ; 11', 11 ") présentent un tronçon cintré en forme de S.

9. Manipulateur selon la revendication 8, **caractérisé en ce que** les tronçons cintrés en forme de S de tous les bras de ressort (9', 11') sont agencés avec la même orientation.

10. Manipulateur selon la revendication 8, **caractérisé en ce que** les tronçons cintrés en forme de S d'une partie des bras à ressort (9", 11 "), et de préférence de la moitié de tous les bras à ressort (9", 11 "), sont orientés en sens opposé aux tronçons cintrés en forme de S de l'autre partie des bras à ressort (9", 11 ").

11. Manipulateur selon l'une des revendications précédentes, **caractérisé en ce que** les bras à ressort (9, 9', 9" ; 11, 11', 11") sont reliés au poussoir (3) et au cadre (7) en des points de fixation qui sont situés sur un cercle commun.

12. Manipulateur selon l'une des revendications précédentes, **caractérisé en ce que** le poussoir (3) est guidé de façon linéaire par au moins deux plaques-ressorts (6, 6', 6") écartées axialement.

13. Manipulateur selon la revendication 12, **caractérisé en ce qu'**au moins une première plaque-ressort (6, 6', 6") est agencée au voisinage du berceau (5) et au moins une autre plaque-ressort (6, 6', 6") est agencée au voisinage du dispositif de production de mouvement (2), soit du même côté que la première plaque-ressort (6, 6', 6"), soit au-delà du dispositif de production de mouvement (2).
